Europäisches Patentamt

European Patent Office

Office européen des brevets

(19)

(11) EP 0 569 572 B1

(12) **EUROPÄISCHE PATENTSCHRIFT**

(45) Veröffentlichungstag und Bekanntmachung des Hinweises auf die Patenterteilung:
**04.02.1998 Patentblatt 1998/06**

(21) Anmeldenummer: 92923788.1

(22) Anmeldetag: **25.11.1992**

(51) Int Cl.⁶: **G01R 27/04**

(86) Internationale Anmeldenummer:
**PCT/EP92/02711**

(87) Internationale Veröffentlichungsnummer:
**WO 93/11439 (10.06.1993 Gazette 1993/14)**

(54) **VERFAHREN ZUR BESTIMMUNG VON ELEKTROMAGNETISCHEN IMPEDANZEN IM FREQUENZBEREICH ZWISCHEN 0 HZ UND 10 GHZ**

METHOD OF DETERMINING ELECTROMAGNETIC IMPEDANCES IN THE FREQUENCY RANGE BETWEEN 0 HZ AND 10 GHZ

PROCEDE POUR LA DETERMINATION D'IMPEDANCES ELECTROMAGNETIQUES DANS LA GAMME DE FREQUENCES COMPRISE ENTRE 0 HZ ET 10 GHZ

(84) Benannte Vertragsstaaten:
**DE ES FR GB**

(30) Priorität: **30.11.1991 DE 4139622**

(43) Veröffentlichungstag der Anmeldung:
**18.11.1993 Patentblatt 1993/46**

(73) Patentinhaber: **PELSTER, Rolf**
**51519 Odenthal-Glöbusch (DE)**

(72) Erfinder: **PELSTER, Rolf**
**51519 Odenthal-Glöbusch (DE)**

(74) Vertreter: **Selting, Günther, Dipl.-Ing. et al**
**Patentanwälte**
**von Kreisler, Selting, Werner**
**Postfach 10 22 41**
**50462 Köln (DE)**

(56) Entgegenhaltungen:
**EP-A- 0 064 413          EP-A- 0 333 521**

- **MICROWAVE JOURNAL Bd. 26, Nr. 4, April 1983, DEDNAM,MASS,US Seiten 95 - 102 PAUL 'wideband millimeter-wave impedance measurements'**

**Beschreibung**

Die Erfindung betrifft ein Verfahren nach dem Oberbegriff der Patentansprüche 1 und 9.

In der Entwicklung und Produktion passiver elektronischer Bauelemente, z. B. von Kondensatoren und Drosselspulen, sind Messungen des Realteils $Z_1$ und des Imaginärteils $Z_2$ einer komplexen elektromagnetischen Impedanz $Z = Z_1 + iZ_2$ als Funktion von Frequenz und Temperatur unverzichtbar. In der Werkstoffentwicklung bzw. Produktionskontrolle ist man darüber hinaus an dielektrischen und magnetischen Materialparametern interessiert, die ebenfalls über Impedanzmessungen bestimmt werden.

Zur Charakterisierung eines Bauelementes oder Materials werden präzise und breitbandige Verfahren zur Bestimmung komplexer Impedanzen benötigt, die sämtliche Fehler eliminieren, die durch den Meßaufbau mit seinen Leitungen hervorgerufen werden. Solange die Wellenlängen der benutzten elektromagnetischen Wellen viel größer sind als die Leitungslängen, ist die elektrotechnische Beschreibungsweise hinreichend exakt, d. h. jeder Aufbau kann als Verknüpfung punktförmiger Bauelemente aufgefaßt werden. Oberhalb von ca. 1 MHz machen sich jedoch zusätzliche Effekte bemerkbar, die mit Hilfe der Leitungstheorie beschrieben werden, in deren Rahmen dann auch allgemeiner von Übertragungsleitungen gesprochen wird (siehe: K. Küpfmüller, Einführung in die theoretische Elektrotechnik, Springer, 11. Aufl., 1984, Kapitel 5). An allen Leitungsdiskontinuitäten treten Reflektionen von Strom oder Spannung auf. Zwischen diesen Diskontinuitäten kommt es daher zu Mehrfachreflektionen, so daß sich Strom und Spannung entlang der Übertragungsleitung als Funktion des Ortes abweichend von der elektrotechnischen Beschreibung ändern. Aber auch entlang homogener Leitungen machen sich Phasenvariationen von Strom und Spannung bemerkbar. Da die Phasenlänge einer Leitung proportional zur Frequenz ist, wird der Einfluß dieser Effekte mit steigender Meßfrequenz immer stärker. Daher müssen diese und die Effekte der Mehrfachreflektionen bei einer Impedanzbestimmung berücksichtigt werden, um das tatsächliche Spannungs-Strom-Verhältnis zu ermitteln, durch welches die Impedanz definiert ist.

Bis heute existiert jedoch kein präzises Verfahren zur Bestimmung komplexer Impedanzen, das sowohl im niederfrequenten Bereich von 0-10 MHz arbeitet, als auch bis in den Mikrowellenbereich von einigen GHz reicht. Man ist daher darauf angewiesen, verschiedene Meßmethoden zu benutzen, um Impedanzen breitbandig zu bestimmen. Dies bedeutet einen größeren apparativen und zeitlichen Aufwand bei der Durchführung und Vorbereitung der Messungen. Darüberhinaus besitzen die bekannten Verfahren oberhalb von 10 MHz verschiedene Nachteile. Im folgenden werden als Stand der Technik verschiedene Meßmethoden im Frequenzbereich zwischen 0 und 10 GHz beschrieben.

a) Impedanzmessung durch Abgleich einer Meßbrücke, z. B. auto frequency bridges, transformer ratio bridges, autobalanced bridges, LCR-meter, Impedanz-Analysatoren etc. (siehe hierzu J. R. Macdonald, Impedance Spectroscopy, J. Wiley & Sons, 1987, 1. Auflage, Kapitel 3).

Beim Abgleich von Meßbrücken werden keine Phasenvariationen und auch keine Mehrfachreflektionen berücksichtigt und daher lassen sich genaue Messungen nur bis maximal 10 MHz durchführen.

b) Messung der Transmissions- und Reflektionskoeffizienten und Berücksichtigung der Zuleitungseinflüsse durch Kalibrierung mit 3 verschiedenen Standards. Ein solches Verahren unter Messung von mindestens 3, bevorzugterweise 4 Standards ist beschrieben in EP-A-0 333 521. Ein Überblick über die Vielzahl der möglichen Verfahren wird gegeben in: A Generalized Theory and New Calibration Procedures for Network Analyzer Self-Calibration, H. J. Eul and B. Schiek, IEEE Transactions on Microwave Theory and Techniques, Vol. 39, No. 4, April 1991.

Bei all diesen Verfahren nach Punkt b) werden Reflektions- und Transmissionskoeffizienten einer Übertragungsstrecke, welche eine Meßzelle mit der zu bestimmenden Impedanz enthält, für beide möglichen Signalrichtungen gemessen, d. h. 4 komplexe Werte pro Meßfrequenz. Einflüsse der Zuleitungen werden in einem 3-Schritt-Verfahren, der Kalibrierung, eliminiert, wobei anstelle der Meßzelle nacheinander drei verschiedene Standards an die Zuleitungen angeschlossen und die Reflektions- und Transmissionskoeffizienten gemessen werden. Neben dem hohen Zeitaufwand, dem größeren technischen Aufwand (Brücken zur Auskopplung der reflektierten Signale, Umkehr der Signalrichtung) gibt es zwei grundsätzliche Nachteile dieses Verfahrens, die Anwendbarkeit und Genauigkeit beschränken. Die verwendeten Standards ändern ihre Eigenschaften in Abhängigkeit von der Temperatur in nicht bekannter Weise, so daß eine Bestimmung der Zuleitungseinflüsse nur bei Raumtemperatur möglich ist (dies gilt nicht für Verfahren, die verschiedene Leitungslängen zur Kalibrierung benutzten. Diese sind jedoch nicht breitbandig und im betrachteten Frequenzbereich auf Grund der großen Wellenlängen nicht zu realisieren). Somit lassen sich präzise Impedanzmessungen nur in der Nähe der Raumtemperatur durchführen. Insbesondere werden aber die Einflüsse der eigentlichen Meßzelle, welche die zu untersuchende Impedanz enthält, nur berücksichtigt, wenn sie reflektionsfrei an die Leitungsimpedanz angepaßt ist (die Phasenlänge der Meßzelle muß z. B. mit einer zusätzlichen Transmissionsmessung bestimmt werden). Dies ist eine idealisierende Annahme, die nur sehr schwer zu realisieren ist und die Genauigkeit der Impedanzmessung und die möglichen Geometrien der Meßzellen einschränkt.

In der US Patentschrift 4,982,164 (Januar 1991) weisen Schiek et al. darauf hin, daß bei der Kalibrierung von Netzwerkanalysatoren für reine Impedanzmessungen die Verwendung von 2 Kalibrierstandards ausreichend ist. Aber auch in diesem Fall werden die jeweiligen Reflektions- und Transmissionskoeffizienten gemessen, so daß sowohl der gerätetechnische als auch der Auswerte-Aufwand hoch bleiben.

c) Messung von Reflektionskoeffizienten mit Impedanz-Analysatoren oder Netzwerkanalysatoren (z. B. Probe als Abschluß einer Koaxialleitung, siehe hierzu: A. Rost, Messung dielektrischer Stoffeigenschaften, Vieweg, 1978, 1. Auflage, Kapitel 4.3).

Diese Verfahren sind unterhalb von 1 MHz nicht zu verwenden und erlauben nicht die Auflösung von Verlustwinkeln $Z_1/Z_2$, deren Werte kleiner als $10^{-1}$, bestenfalls kleiner $10^{-2}$ sind. (siehe z. B. N.-E. Belhadj-Tahar, These de doctorat de l'Université Pierre et Marie Curie, Paris IV, 1986). Die Einflüsse der Zuleitung werden wie bei den in Punkt b) beschriebenen Verfahren mit Hilfe von drei verschiedenen Standards bestimmt, so daß sich für temperaturabhängige Messungen die gleichen Einschränkungen ergeben.

Die Oberbegriffe der Ansprüche 1 und 2 gehen aus von einem Verfahren zur Bestimmung von elektromagnetischen Impedanzen, wie es in der Publikation "Wideband millimeter-wave impedance measurements", J.A. Paul, Microwave Journal, Bd. 26, Nr.4, April 1983, Dedham, Mass., U.S., S. 95-102, beschrieben ist. Bei einem dort beschriebenen Verfahren wird für die Kalibrierung ein einziger Standard vermessen. Dies wird als Frequenzgang-Kalibrierung bezeichnet (sogenannte "response-calibration" oder "normalize"). Dabei werden Phasenvariationen und Dämpfungen der Zuleitungen berücksichtigt. Fehlanpassungen und Mehrfachreflektionen sowie die endliche Direktivität verfälschen aber die Messungen, was zu Meßfehlern größer 3 dB führen kann. Dieses Verfahren kann im Hochfrequenzbereich oberhalb 1 MHz bei der Verwendung gut angepaßter Hohlleitertechnik benutzt werden, allerdings nur in den typischen Bandbreiten von Hohlleitern, die weniger als eine Frequenzdekade beträgt.

Der Erfindung liegt die Aufgabe zugrunde, ein Verfahren anzugeben, bei dem mit einfachen Mitteln eine Bestimmung des Real- und Imaginärteils von elektromagnetischen Impedanzen im Frequenzbereich zwischen 0 Hz und 10 GHz, vorzugsweise von 0 Hz bis 2 GHz, durch Messung des komplexen Transmissionskoeffizienten einer Übertragungsstrecke oder im Fall einer ideal angepaßten und somit reflexionsfreien Signalquelle durch Messung der komplexen Spannung an einer ausgangsseitig an der Übertragungsstrecke angeschlossenen Abschlußimpedanz möglich ist.

Die Lösung dieser Aufgabe erfolgt erfindungsgemäß mit den Merkmalen der Patentansprüche 1 oder 2.

Es wurde nun ein besonders vorteilhaftes Verfahren zur Bestimmung des Real- und Imaginärteils von elektromagnetischen Impedanzen im Frequenzbereich zwischen 0 Hz und 10 GHz, vorzugsweise von 0 Hz bis 2 GHz, durch Messung des Real- und Imaginärteils der Transmissionskoeffizienten oder von äquivalenten Übertragungskenngrößen einer Übertragungsstrecke, die aus einer Übertragungsleitung mit einer in die Übertragungsleitung eingeschalteten Meßzelle und einer ausgangsseitig angeschlossenen Abschlußimpedanz besteht, gefunden. Die erfindungsgemäße Vorgehensweise besteht darin, daß man

(a) die zu bestimmende Impedanz Z in der Meßzelle an zwei Elektroden anschließt oder zwischen diesen realisiert und den resultierenden Transmissionskoeflizienten $S_{21}^{mess}$ der Übertragungsstrecke mißt und

(b) an dieselben Elektroden wie in (a) anstelle der zu bestimmenden Impedanz nacheinander zwei Impedanzen, $Z_a$ und $Z_b$, anschließt oder zwischen diesen realisiert, wobei $Z_a$ und $Z_b$ bekannte und voneinander verschiedene Impedanzwerte besitzen, und die zwei resultierenden nichtverschwindenden Transmissionskoeffizienten der Übertragungsstrecke, $S_{21}^a$ und $S_{21}^b$, nacheinander mißt und

(c) den Impedanzwert der zu bestimmenden Impedanz aus den drei gemessenen Transmissionskoeffizienten und den Impedanzwerten der beiden bekannten Impedanzen berechnet.

Ist die zu bestimmende Impedanz Z in Bezug auf die Abschlußimpedanz der Übertragungsstrecke in Serie geschaltet, so berechnet sich Z nach der Formel:

$$Z = \frac{Z_a S_{21}^a (S_{21}^b - S_{21}^{mess}) + Z_b S_{21}^b (S_{21}^{mess} - S_{21}^a)}{S_{21}^{mess}(S_{21}^b - S_{21}^a)} \tag{1}$$

Im Falle der Parallelschaltung berechnet sich Z nach:

$$Z = \frac{S_{21}^{mess}(S_{21}^b - S_{21}^a)}{S_{21}^a(S_{21}^b - S_{21}^{mess})/Z_a + S_{21}^b(S_{21}^{mess} - S_{21}^a)/Z_b} \tag{2}$$

Werden Impedanzen mit unterschiedlichen geometrischen Längen benutzt, d. h. ändert sich der geometrische Elektrodenabstand bei den jeweiligen Messungen der Transmissionskoeffizienten, so kann der Elektrodenabstand rechnerisch konstant gehalten werden, indem die Phasen der gemessenen Transmissionskoeffizienten $S_{21}^{a}$ und $S_{21}^{b}$ entsprechend der jeweiligen Längendifferenz zwischen unbekannter und bekannter Impedanz korrigiert werden. Diese Vorgehensweise wird in Beispiel 4 näher erläutert.

Die Transmissionskoeffizienten $S_{21}^{a}$, $S_{21}^{b}$ und $S_{21}^{mess}$ sind im allgemeinen Funktionen der Frequenz, der Temperatur (hervorgerufen durch thermische Ausdehnungen von Zuleitungen und Meßzelle) und des Elektrodenabstandes. Mit breitbandigen modernen Netzwerkanalysatoren kann beispielsweise jeder Transmissionskoeffizient direkt als Funktion der Frequenz gemessen werden, bevor die nächste Impedanz an die Elektroden angeschlossen oder zwischen ihnen realisiert wird. Eine Besonderheit des Verfahrens besteht darin, daß gemäß Punkt (b) die Meßzelle während der 3 Transmissionsmessungen unverändert in der Übertragungsstrecke bleibt und lediglich die Impedanzen $Z$, $Z_a$ und $Z_b$ ausgetauscht werden.

Die Transmissionskoeffizienten $S_{21}^{a}$ und $S_{21}^{b}$ dürfen nicht verschwinden, d. h. es muß gelten $S_{21}^{a} \neq 0$ und $S_{21}^{b} \neq 0$. Im Fall der seriellen Schaltung (Gleichung 1) bedeutet das, daß für die Beträge der bekannten Impedanzen $Z_a$ und $Z_b$ gelten muß $|Z_a| < \infty$ und $|Z_b| < \infty$, so daß die zugehörigen Transmissionskoeffizienten meßbar bleiben. Ist die zu bestimmende Impedanz in Bezug auf die Abschlußimpedanz der Übertragungsstrecke parallel geschaltet (Gleichung 2), so muß gelten $Z_a \neq 0$ und $Z_b \neq 0$. Unter bekannter Impedanz ist zu verstehen, daß der Impedanzwert bekannt ist oder mit einem bekannten Verfahren ermittelt werden kann. In Beispiel 1 wird gezeigt, wie man bei breitbandigen Messungen den Wert der Impedanz $Z_b$ aus $S_{21}^{a}$ und $S_{21}^{b}$ für jede Frequenz ermitteln kann, wenn man lediglich ein bestimmtes Frequenzverhalten von $Z_b$ voraussetzt. Als Impedanzen $Z_a$ und $Z_b$ können z. B. Kurzschlüsse, ohmsche Widerstände, Kondensatoren mit und ohne Material zwischen den Kondensatorflächen, Spulen oder Kombinationen dieser Impedanzen benutzt werden. Die Impedanzen $Z_a$ und $Z_b$ können beispielsweise elektrotechnische Bauelemente sein, die an die Elektroden angeschlossen werden. Sie können auch mit Hilfe der Elektroden realisiert werden, die z. B. wie ein Plattenkondensator wirken können, wenn sie flächig ausgeformt sind.

Das Verfahren läßt sich besonders vorteilhaft durchführen, wenn die zu bestimmende Impedanz in Bezug auf die Abschlußimpedanz der Übertragungsstrecke in Serie geschaltet ist. In diesem Fall ist es vorteilhaft, für eine bekannte Impedanz, z. B. für $Z_a$, einen metallischen Kurzschluß zu wählen. Eine geeignete Wahl für $Z_a$ und $Z_b$ ist beispielsweise die Verwendung eines metallischen Kurzschlusses und einer Spule oder die Verwendung eines metallischen Kurzschlusses und eines Kondensators. Sind zudem die Elektroden der Meßzelle flächig ausgeformt, so sind folgende Wahlmöglichkeiten für $Z_a$ und $Z_b$ besonders vorteilhaft:

i) Verwendung eines metallischen Kurzschlusses $Z_a = 0$ und Realisierung von $Z_b$ durch die Impedanz der durch die Elektroden gebildeten Kondensatoranordnung, wobei sich zwischen den Elektroden ein Luftspalt befindet.

ii) Verwendung eines metallischen Kurzschlusses $Z_a = 0$ und Realisierung von $Z_b$ durch die Impedanz der Elektroden, zwischen denen sich ein Material mit beliebiger, aber im verwendeten Frequenzbereich frequenzunabhängiger und verlustfreier dielektrischer Funktion, befindet. Es kann sich hierbei z. B. um einen ringförmigen Abstandshalter aus Teflon oder Quarzglas handeln. Es ist auch möglich, ein Material mit beliebiger, aber im verwendeten Frequenzbereich bekannter dielektrischer Funktion zu verwenden.

Die Messung der Transmissionskoeffizienten erfolgt i. a. durch die Messung der Spannungen an der Abschlußimpedanz $Z_o$ der Übertragungsstrecke und der Spannungen an der Abschlußimpedanz eines sogenannten Referenzarms, wie es in Beispiel 1 diskutiert wird. Gleichung 1 und 2 sind aber unabhängig von der Leitungsimpedanz der Übertragungsleitung oder von der Wahl der Abschlußimpedanz $Z_o$ der Übertragungsstrecke, deren Wert unbekannt sein darf. Ist die zu bestimmende Impedanz in Bezug auf die Abschlußimpedanz $Z_o$ der Übertragungsstrecke in Serie geschaltet, so ist bei großen Impedanzen $Z$, z. B. mit einem Betrag des Impedanzwertes $|Z| > 20\ k\Omega$, folgende Vorgehensweise besonders vorteilhaft: Zur Erhöhung der Meßgenauigkeit kann man unterhalb von 0.1-1 MHz eine große Abschlußimpedanz, z. B. $Z_o = 1\ M\Omega$, verwenden, die nicht an die Leitungsimpedanz angepaßt ist, während die Abschlußimpedanz des Referenzarmes z. B. $50\Omega$ beträgt. Bei Frequenzen oberhalb von 1 MHz sollten die beiden Abschlußimpedanzen allerdings gleich der Leitungsimpedanz sein. Moderne Netzwerkanalysatoren mit umschaltbaren Abschlußimpedanzen erlauben beispielsweise diese Vorgehensweise. Zudem kann bei Verwendung solcher Geräte die Messung der Transmissionskoeffizienten sehr schnell und über einen großen Frequenzbereich erfolgen.

Im Falle ideal angepaßter und somit reflektionsfreier Signalquellen, die auch bei hohen Frequenzen eine lastunabhängige Ausgangsspannung liefern, könnte man auf einen Referenzarm im Meßaufbau verzichten und lediglich die Spannungen an der Abschlußimpedanz $Z_o$ der Übertragungsstrecke messen. Diese sind dann den Transmissionskoeffizienten äquivalente Übertragungskenngrößen. In Gleichung 1 bzw. Gleichung 2 sind die Transmissionskoeffizienten dann durch die entsprechenden Spannungen zu ersetzen. Solch breitbandig ideale Signalquellen sind bisher jedoch technisch noch nicht realisiert worden, so daß diese Vorgehensweise nur in einem eingeschränkten Frequenzbereich möglich ist.

Das erfindungsgemäße Verfahren erlaubt auch die Bestimmung dielektrischer und magnetischer Materialparameter. Die Bestimmung der dielektrischen Funktion eines Materials erfolgt besonders geeignet durch die Bestimmung der Impedanz einer Kondensatoranordnung, die aus den zu Flächen ausgeformten metallischen Elektroden der Meßzelle und dem Material zwischen diesen Flächen besteht. Aus der bestimmten Impedanz kann dann in bekannter Weise Real- und Imaginärteil der dielektrischen Funktion berechnet werden. Die komplexe magnetische Permeabilität eines Materials kann beispielsweise durch die Bestimmung der Impedanz einer Spule, in welcher sich das Material befindet, ermittelt werden (siehe Beispiel 3).

Die Vorteile des erfindungsgemäßen Verfahrens sind im einzelnen:

1.) Das Verfahren ist extrem breitbandig (0 Hz bis zu 10 GHz), wobei die obere Grenzfrequenz von der Größe und Geometrie der Elektroden zum Anschluß der zu bestimmenden Impedanz und von der Konstruktion der Meßzelle abhängt.

2.) Es werden lediglich Transmissionsmessungen benötigt, d. h. Signaldetektoren und Brücken oder Richtkoppler zur Erfassung reflektierter Signale sind nicht nötig. Der gerätetechnische Aufwand bleibt somit gering und die Messungen können schneller durchgeführt werden.

3.) Sämtliche Einflüsse der Übertragungsleitung und der Meßzelle werden durch lediglich zwei Messungen analytisch erfaßt, d. h. es gibt keine systematischen Fehler bei der Bestimmung der Impedanz, die auf mathematischen Näherungen beruhen.

4.) Die Meßzelle, die die zu bestimmende Impedanz enthält, muß nicht der Leitungsimpedanz angepaßt sein. Damit ist eine Vielzahl von verschiedenen Meßzellen möglich. Durch geeignete Wahl der Geometrie von Meßzelle und Elektroden kann so z. B. der bei der Bestimmung der dielektrischen Materialparameter nötige Aufwand zur Probenpräparation erheblich verringert werden.

5.) Temperaturabhängige Messungen sind möglich.

6.) Meßbereich und Genauigkeit des Verfahrens sind sehr hoch. Auch sehr kleine Impedanzwerte mit $Z_1 < 1\ \Omega$ und Impedanzen mit kleinem Verlustwinkel ($Z_1/Z_2 < 10^{-3}$ bei Messungen mit modernen Netzwerkanalysatoren) sind breitbandig bestimmbar.

7.) Die zwei bekannten Impedanzen lassen sich sehr einfach realisieren. Man kann also z. B. bei der Bestimmung der dielektrischen Materialparameter den Abstand der Elektroden der Länge der verfügbaren Materialprobe anpassen, was den Aufwand bei der Probenpräparation verringert.

8.) Im Falle einer Kondensatoranordnung zur Bestimmung der dielektrischen Funktion eines Materials liefert das Verfahren eine implizite Streufeldkorrektur, so daß auf die im Niederfrequenzbereich übliche Schutzringanordnung oder auf die sonst nötige und nur näherungsweise gültige mathematische Korrektur verzichtet werden kann.

In den Abbildungen zeigt:

Abb. 1    eine Meßanordnung zur Impedanzbestimmung eines Plattenkondensators,
Abb. 2    das zugehörige elektrotechnische Ersatzschaltbild,
Abb. 3    die dielektrische Funktion einer Keramikprobe, die über eine erfindungsgemäße Impedanzmessung bestimmt wurde,
Abb. 4    eine Meßanordnung zur Bestimmung der komplexen Impedanz einer Spule, die ein magnetisches Material enthält, und
Abb. 5    das zugehörige elektrotechnische Ersatzschaltbild.

Die Bedeutung der in den Zeichnungen 1,2,4 und 5 verwendeten Symbole wird in Beispiel 1 (S. 7,8) und Beispiel 3 (S. 14) erläutert.

Beispiel 1

Im folgenden wird die Erfindung am Beispiel der Impedanzbestimmung eines Plattenkondensators erläutert. Zwischen den beiden kreisrunden Kondensatorplatten $P$ befindet sich eine zylinderförmige Materialprobe $M$ mit Radius

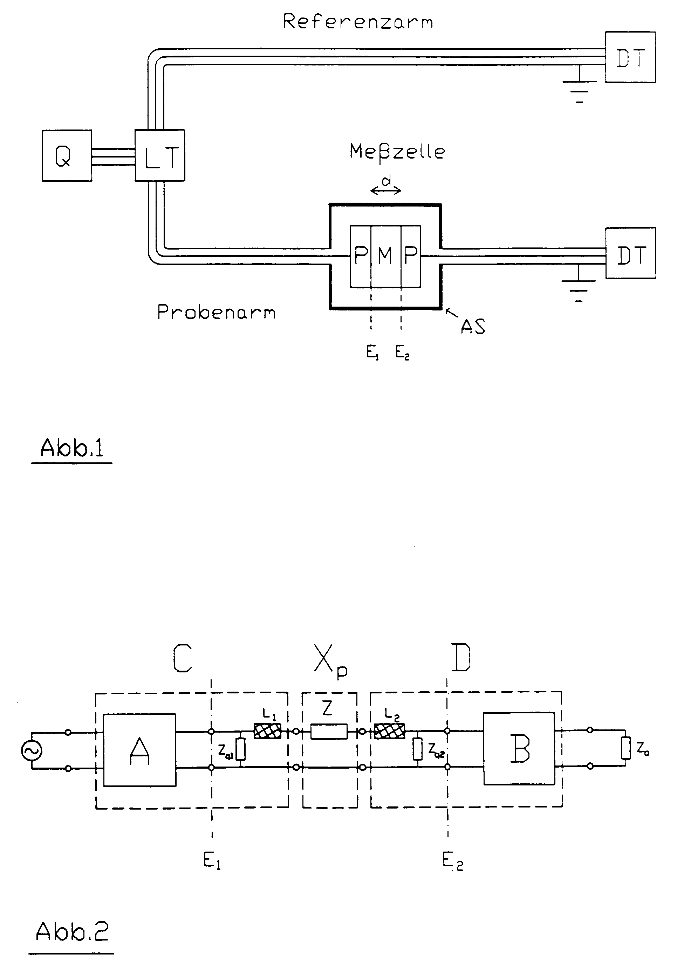

$a_p$ und Länge $d$, deren komplexe dielektrische Funktion über die Bestimmung der Impedanz ermittelt werden soll. Die Meßzelle besteht aus der Abschirmung $AS$ und dem Plattenkondensator, der seriell in eine Koaxial-Übertragungsleitung geschaltet ist (Abb. 1). Die Platten $P$ des Kondensators sind flächig ausgebildete Elektroden. Eine Spannungsquelle $Q$ liefert ein sinusförmiges Signal der Frequenz $v$, welches über einen Leistungsteiler $LT$ in den Probenarm, der die Meßzelle enthält, und in den Referenzarm gegeben wird. Gemessen wird das Spannungsverhältnis an den Abschlußimpedanzen im Proben- und Referenzarm nach Betrag und Phase (oder Real- und Imaginärteil, was dazu äquivalent ist), d. h. der komplexe Transmissionskoeffizient der Übertragungsstrecke vom Leistungsteiler $LT$ bis zum Detektor $DT$ des Probenarms, bezogen auf die im Detektor $DT$ des Referenzarms gemessene Spannung, wobei die Abschlußimpedanzen durch die Detektoren selbst realisiert werden.

Das Ersatzschaltbild der Anordnung ist in Abb. 2 zu sehen. In den Abbildungen und im Text werden folgende Symbole benutzt:

| | |
|---|---|
| P | Kondensatorplatten mit kreisförmiger Querschnittsfläche |
| AS | zylinderförmige Abschirmung der Meßzelle |
| d | Abstand der Kondensatorplatten, d. h. Länge der Materialprobe |
| M | Materialprobe |
| Z | zu bestimmende komplexe Impedanz, hier also die Impedanz des Plattenkondensators mit dem Material M zwischen den Platten |
| $E_1, E_2$ | Bezugsebenen, in denen die Oberflächen der Kondensatorplatten P liegen |
| Q | Spannungsquelle |
| DT | Detektor |
| LT | Leistungsteiler |
| $Z_o$ | komplexe Abschlußimpedanz des Probenarms |
| A,B | komplexe Betriebskettenmatrizen der Fehlerzweitore, die die Einflüsse der Koaxial-Übertragungsleitung und des Meßaufbaus bis zu den Bezugsebenen $E_1$ bzw. $E_2$ repräsentieren |
| $L_1, L_2$ | komplexe Induktivitäten im Bereich zwischen $E_1$ und $E_2$ |
| $Z_{q1}, Z_{q2}$ | komplexe Impedanzen zwischen Mittelleiter und Abschirmung im Bereich zwischen $E_1$ und $E_2$ |
| C,D | komplexe Betriebskettenmatrizen der erweiterten Fehlerzweitore, die auch die Einflüsse von $Z_{q1}, Z_{q2}, L_1$ und $L_2$ enthalten |
| $X_p$ | komplexe Betriebskettenmatrix des Zweitors, welches nur die Impedanz Z enthält |
| T | komplexe Betriebskettenmatrix der Übertragungsstrecke. Es gilt $T = C \cdot X_p \cdot D$. |
| $v$ | Meßfrequenz |
| $\omega$ | Kreisfrequenz, $\omega = 2\pi v$ |
| $Z_a, Z_b$ | komplexe Impedanzen |
| $S_{21}^{mess}$ | gemessener komplexer Transmissionskoeffizient, wenn sich das Material M zwischen den Kondensatorplatten befindet |
| $S_{21}^a, S_{21}^b$ | gemessener komplexer Transmissionskoeffizient, wenn sich die Impedanz $Z_a$ bzw. $Z_b$ zwischen den Kondensatorplatten befindet oder zwischen diesen realisiert wird |
| $\varepsilon$ | komplexe relative dielektrische Funktion der Materialprobe |
| $\varepsilon_o$ | Permeabilität des Vakuums, $\varepsilon_0 = 8.854 \ 10^{-12} F/m$ |
| $a_e$ | Radius der Kondensatorplatten |
| $A_e$ | Fläche einer Kondensatorplatte, $A_e = \pi a_e^2$ |
| $a_p$ | Radius der Materialprobe , $a_p \leq a_e$ |
| $A_p$ | Querschnittsfläche der Materialprobe, $A_p = \pi a_p^2 \leq A_e$ |
| b | Innenradius der zylinderförmigen Abschirmung der Meßzelle |
| $C_{streu}$ | Streukapazität des von den Platten P gebildeten Kondensators auf Grund von Randeffekten |
| $C_e$ | Kapazität des von den Platten P gebildeten Kondensators ohne Randeffekte, wenn sich kein Material zwischen den Platten befindet, $C_e = \varepsilon_o A_e/d$ |
| Cb | Kapazität des von den Platten P gebildeten Kondensators, zwischen denen sich kein Material befindet, $C_b = C_e + C_{streu}$ |
| $\mu$ | komplexe relative magnetische Permeabilität des Materials |
| $\kappa$ | komplexer Wellenvektor, |

$$\kappa = \frac{\omega}{c}\sqrt{\varepsilon\mu}$$

| | |
|---|---|
| c | Lichtgeschwindigkeit im Vakuum, $c = 2.9979 \cdot 10^8$ m/s |
| $J_o$ | komplexe Besselfunktion 0-ter Ordnung |

$J_1$          komplexe Besselfunktion 1-ter Ordnung

Die Betriebskettenmatrizen $A,B,C,D,X_P$ und $T$ sind komplexe $2 \times 2$-Matrizen, deren Elemente mit Hilfe von doppelten Indizes angegeben werden. Die vier Elemente der Matrix $T$ sind also z. B. $T_{11},T_{12},T_{21}$ und $T_{12}$. Die Impedanzen $Z_{q1}$ und $Z_{q2}$ sind im wesentlichen durch Kapazitäten zwischen den in den Ebenen $E_1$ und $E_2$ liegenden Rändern der Elektrodenoberflächen und der Abschirmung der Meßzelle und auch durch Abstrahlverluste bei höheren Frequenzen gegeben. Sie sind im verwendeten Frequenzbereich unabhängig von der Impedanz Z. $L_1$ und $L_2$ sind die Eigeninduktivitäten der Anordnung im Bereich zwischen $E_1$ und $E_2$, die durch die geometrische Struktur der Meßzelle gegeben sind. Daher können die Betriebskettenmatrizen A und B erweitert werden, so daß sich ein neues vereinfachtes Ersatzschaltbild ergibt. Die Impedanz Z befindet sich in serieller Schaltung zwischen den beiden Fehlerzweitoren mit den Betriebskettenmatrizen C und D. Da $Z_{q1},Z_{q2},L_1$ und $L_2$ vom Abstand d der Kondensatorplatten abhängen, gilt dies nun auch für die Matrizen C und D. Zwischen den Reflektions- und Transmissionskoeffizienten eines Zweitors, den sogenannten S-Parametern, und den Elementen der zugehörigen Betriebskettenmatrix X besteht folgender Zusammenhang (nach: H. Freitag, Einführung in die Zweitortheorie, Teubner Studienskripten, 1984, 3. Auflage, Kapitel 12, S. 149):

$$X_{11} = -S_{11}S_{22}/S_{21} + S_{12}$$

$$X_{12} = S_{11}/S_{21}$$

$$X_{21} = -S_{22}/S_{21}$$

$$X_{22} = 1/S_{21}$$

mit

$S_{21}, S_{12}$      Transmissionskoeffizienten des Zweitors
$S_{11}, S_{22}$      Reflektionskoeffizienten des Zweitors jeweils für beide mögliche Signalrichtungen

Die S-Parameter für das Zweitor, das lediglich aus der Probenimpedanz Z zwischen den Zweitoren mit den Betriebskettenmatrizen C und D besteht, lauten:

$$S_{21}^p = S_{12}^p = \frac{1}{\dfrac{Z}{2Z_o} + 1}$$

$$S_{11}^p = S_{22}^p = S_{21}^p \cdot \frac{Z}{2Z_o}$$

$X_p$ bezeichne die zugehörige Betriebskettenmatrix. Die Betriebskettenmatrix des Gesamtsystems ergibt sich nun aus der Multiplikation der Betriebskettenmatrizen der hintereinandergeschalteten Zweitore, also:

$$T = C \cdot X_p \cdot D$$

$1/T_{22}$ ist aber der gemessene Transmissionskoeffizient $S_{21}^{mess}$ des Gesamtsystems und daher

$$S_{21}^{mess} = \frac{N}{KZ + 1} \tag{3}$$

mit

$$N = \frac{1}{C_{21}D_{12} + C_{22}D_{22}}$$

$$K = \frac{N}{2Z_o} \cdot (-C_{21}D_{12} + C_{22}D_{22} + C_{21}D_{22} - C_{22}D_{12})$$

N und K sind Funktionen der Frequenz, der Temperatur (hervorgerufen durch thermische Ausdehnungen von Zuleitungen und Meßzelle) und des Plattenabstandes d und müssen durch zwei weitere Transmissionsmessungen, die sogenannte Kalibrierung, bestimmt werden. Dazu reichen zwei Messungen mit zwei unterschiedlichen Impedanzen, $Z_a$ und $Z_b$, die sich anstelle der Impedanz Z zwischen den Elektroden befinden, aus, vorausgesetzt, daß die Funktionen N und K dabei unverändert bleiben. Die Impedanzen müssen endlich sein, d. h. für ihre Beträge muß gelten $|Z_a|$, $|Z_b|$ < ∞, so daß die zugehörigen Transmissionskoeffizienten nicht verschwinden und damit meßbar bleiben.

Bezeichnen $S_{21}^a$ und $S_{21}^b$ nun die gemessenen Transmissionskoeffizienten der Anordnung mit den Impedanzen $Z_a$ bzw. $Z_b$ an Stelle der zu bestimmenden Impedanz Z, so folgt aus Gleichung 3 die Bestimmungsgleichung für Z:

$$Z = \frac{Z_a S_{21}^a (S_{21}^b - S_{21}^{mess}) + Z_b S_{21}^b (S_{21}^{mess} - S_{21}^a)}{S_{21}^{mess}(S_{21}^b - S_{21}^a)} \tag{4}$$

Wichtige Vorraussetzung bei dieser Vorgehensweise ist, daß die Messungen der Transmissionskoeffizienten unter unveränderten Meßbedingungen erfolgen und daß nur die Impedanzen Z, $Z_a$ und $Z_b$ ausgetauscht werden. Der übrige Meßaufbau bleibt unverändert, insbesondere natürlich der Abstand der Elektroden.

Für $Z_a$ wählt man nun einen zylinderförmigen metallischen Kurzschluß der Länge d und einem Radius $a \leq a_e$, und somit gilt $Z_a = 0$. Die Phasenlänge des Kurzschlusses ist in den Betriebskettenmatrizen C und D bereits berücksichtigt und die Kapazität zwischen den Rändern der in den Ebenen $E_1$ und $E_2$ liegenden Elektrodenoberflächen und der Abschirmung ist bei kleinem Plattenabstand, wie z. B. d=1 mm, gleich der Kapazität zwischen Kurzschluß und Abschirmung, so daß die Betriebskettenmatrizen C und D, wie gefordert, unverändert bleiben. Dies kann bei größeren Werten von d näherungsweise auch durch einen großen Abstand zwischen Kondensatorplatten und Abschirmung erreicht werden, so daß die Impedanzen $Z_{q1}$ und $Z_{q2}$ sehr groß sind und das Signal im Probenarm nicht mehr beeinflussen. Gleichung 4 vereinfacht sich dann zu

$$Z = \frac{\frac{S_{21}^a}{S_{21}^{mess}} - 1}{\frac{S_{21}^a}{S_{21}^b} - 1} \cdot Z_b \tag{5}$$

$Z_b$ wird durch die Impedanz des leeren Plattenkondensators bei gleichem Plattenabstand d realisiert. Bezeichnet $C_b$ die Leerkapazität des Plattenkondensators, so ist

$$Z_b = \frac{1}{i\omega C_b}$$

$C_b$ ist eine reelle Größe und praktisch frequenzunabhängig, solange $\omega a_e/c < 0.3$ gilt, was einer maximalen Abweichung von etwa 1 % bei der höchsten Frequenz entspricht (siehe hierzu: A. Rost, Messung dielektrischer Stoffeigenschaften, Vieweg, 1978, 1. Auflage, Kapitel 4.3, S.133), für einen Plattenradius von $a_e = 6.5$ mm also bis etwa 2 GHz. Da Realteil $Z_1$ und Imaginärteil $Z_2$ der Impedanz Z beide proportional zu der rein imaginären Größe $Z_b$ sind, ist der Verlustwinkel $Z_1/Z_2$ unabhängig von $Z_b$, und auch ohne kenntnis von $Z_b$ exakt bestimmt. Das gleiche gilt bei Verwendung einer rein reellen Impedanz Zb.

$C_b$ kann beispielsweise aus den Messungen von $S_{21}^a$ und $S_{21}^b$ direkt berechnet werden, wenn die Messungen der Transmissionskoeffizienten über einen größeren Frequenzbereich, der auch Frequenzen unterhalb von 1 MHz enthält, duchgeführt werden. Unterhalb von ca. 1 MHz machen sich Reflektionen im Bereich der Zuleitungen kaum bemerkbar, so daß mit $K = 1/(2Z_o)$ aus Gleichung 3 für die frequenzunabhängige Größe $C_b$ folgt (sogenanntes Normalize-Verfahren):

$$C_b = \frac{1}{i\omega 2 Z_o \left( \frac{S_{21}^a}{S_{21}^b} - 1 \right)} \quad \text{für } \nu < 1 \text{ MHz}$$

Dadurch ist $Z_b$ für alle Frequenzen bestimmt und die Impedanz Z läßt sich nach Gleichung 5 berechnen. In dem eingeschränkten Frequenzbereich unterhalb von 0.1-1 MHz kann für den Fall, daß die zu bestimmende Impedanz $Z$ klein ist, z. B. wenn $|Z| < 20$ kΩ gilt, Z auch nach der Formel

$$Z = 2Z_o \left( \frac{S_{21}^a}{S_{21}^{mess}} - 1 \right)$$

berechnet werden. Bei größeren Impedanzwerten ist aber auch unterhalb von 0.1-1 MHz die Benutzung von Gleichung 5 vorteilhaft.

Wird $Z_b$ durch die Impedanz des leeren Plattenkondensators realisiert, so verschwindet der zugehörige Transmissionskoeffizient bei 0 Hz und ist somit nicht meßbar. Die untere Frequenzgrenze wird daher $10^{-x}$ Hz sein, wobei der Wert von x vom Auflösungsvermögen des benutzten Meßinstrumentes abhängt.

Prinzipiell ist es natürlich auch möglich, in Gleichung 5 für $Z_b$ beliebige komplexe Impedanzen zu verwenden, solang $S_{21}^a \neq S_{21}^b$. In diesem Fall müssen die Werte aber für alle Meßfrequenzen als bekannt vorausgesetzt werden. Man kann beispielsweise ein Material mit einer Gleichstromleitfähigkeit (d. h. bei niedrigen Frequenzen ist Imag(ε) α 1/ω) zwischen die Kondensatorplatten bringen. In diesem Fall würde der zugehörige Transmissionskoeffizient bei 0 Hz meßbar bleiben. Das gleiche gilt für die Verwendung eines elektrotechnischen Bauelements, wie z. B. eines ohmschen Widerstandes oder eines Elektrolytkondensators mit Parallelwiderstand, das zwischen die Kondensatorplatten gebracht werden kann.

Eine temperaturabhängige Messung von $S_{21}^a$ und $S_{21}^b$ ist auf Grund der Einfachheit der benutzten Impedanzen $Z_a$ und $Z_b$ natürlich möglich. Somit läßt sich Z als Funktion von Frequenz und Temperatur bestimmen.

Die komplexe dielektrische Funktion ε des Materials berechnet sich aus der bestimmten Impedanz Z durch Lösen der Gleichung

$$\varepsilon \cdot \frac{2 J_1(ka_p)}{ka_p J_o(ka_p)} - \frac{d}{i\omega \varepsilon_o \pi a_p^2} \left( \frac{1}{Z} - i\omega (\varepsilon_o \pi \frac{a_e^2 - a_p^2}{d} + C_{streu}) \right) = 0 \qquad (6)$$

wobei zu beachten ist, daß der Wellenvektor k ebenfalls eine Funktion von ε ist, da $k = \sqrt{\varepsilon \mu} \cdot \omega/c$ (siehe hierzu: A. Rost, Messung dielektrischer Stoffeigenschaften, Vieweg, 1978, 1. Auflage, Kapitel 4.3, S. 133). Somit kann ε z. B. durch numerische Nullstellensuche bestimmt werden. $C_{streu}$ kann aus der bereits bestimmten Kapazität $C_b$ berechnet werden, da

$$C_{streu} = C_b - C_e$$

wobei $C_e$ die theoretische Kapazität des leeren Plattenkondensators ist, wenn man Streufelder vernachlässigt, also $C_e = \varepsilon_o A_e/d$.

Für den Fall $|ka_p| \ll 1$ vereinfacht sich Gleichung 6, so daß sich die bekannte Niederfrequenzformel für Plattenkondensatoren ergibt

$$\varepsilon = \frac{d}{i\omega \varepsilon_o A_p} \left( \frac{1}{Z} - i\omega (\varepsilon_o \frac{A_e - A_p}{d} + C_{streu}) \right)$$

und auch Materialproben mit nicht kreisrundem Querschnitt vermessen werden können.

Bei stark magnetischen Materialien ($|\mu| \gg 1$) ist bei hohen Frequenzen die Ungleichung $|ka_p| \ll 1$ nicht mehr erfüllt. Ist die magnetische Permeabilität $\mu$ des Materials nicht bekannt, so können Messungen an zwei Materialproben gleicher Länge d, aber mit unterschiedlichen Radien durchgeführt werden, um die voneinander unabhängigen Größen $\varepsilon$ und $\mu$ auch bei diesen höheren Frequenzen zu bestimmen. Man erhält dann zwei Bestimmungsgleichungen derselben Form wie Gleichung 6, aber für zwei verschiedene Radien $a_p$, aus denen sich dann die zwei Unbekannten $\varepsilon$ und $\mu$ berechnen lassen.

Beispiel 2

Meßaufbau und Vorgehensweise seien so wie in Beispiel 1 beschrieben, nur mit dem Unterschied, daß für $Z_b$ die Impedanz des Plattenkondensators, zwischen dessen Platten sich ein Material mit beliebiger, aber verlustfreier (d. h. reeller) und frequenzunabhängiger dielektrischer Funktion $\varepsilon_b$ und mit Querschnittsfläche $A_b$ (wobei $A_b \le A_e$) befindet, benutzt wird. Dies kann z. B. ein ringförmiger Abstandshalter der Länge d aus Teflon oder Quarzglas sein. Für die Streukapazität gilt nun

$$C_{streu} = C_b - \varepsilon_o \frac{A_e + (\varepsilon_b - 1)A_b}{d}$$

wohingegen alle anderen im Beispiel 1 aufgeführten Gleichungen ihre Gültigkeit behalten.

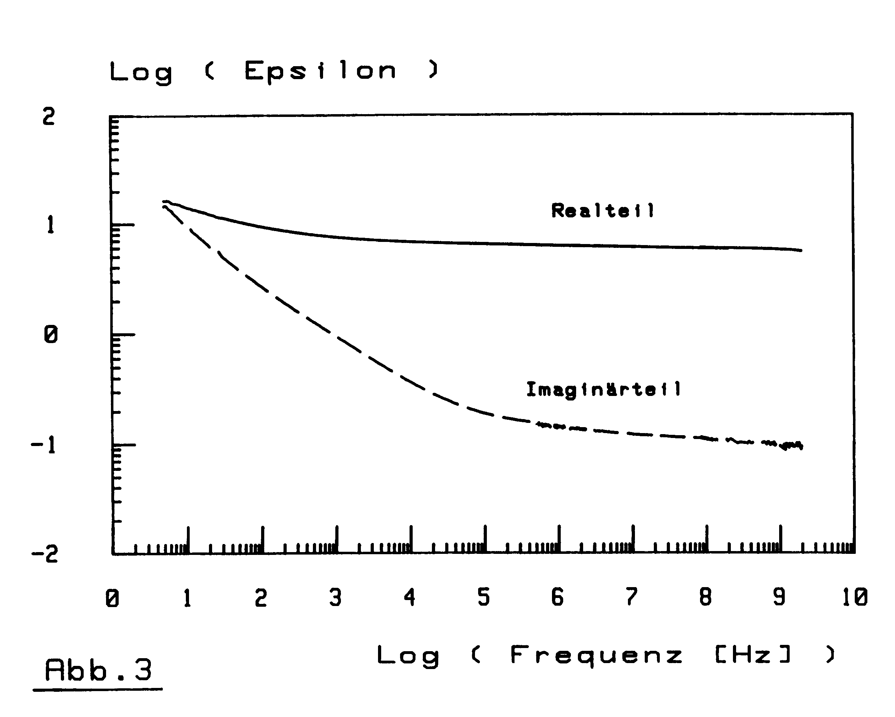

Abbildung 3 zeigt das Ergebnis einer Messung an einer Keramikprobe. Zu sehen sind Real- und Imaginärteil von $\varepsilon$ als Funktion der Frequenz in doppeltlogarithmischer Auftragung, die aus der bestimmten Impedanz des Plattenkondensators mit Materialprobe nach Gleichung 6 berechnet wurden. Zu erkennen sind der extrem breite Frequenzbereich und das hohe Auflösungsvermögen des Verfahrens.

Die Messungen der Transmissionskoeffizienten wurden mit zwei Netzwerkanalysatoren (HP3577B: 5 Hz-200 MHz/ HP8510B: 80 MHz- 2 GHz) durchgeführt. Der Radius der Kondensatorplatten und der Materialprobe war $a_e = a_p = 6,5\ mm$, der Plattenabstand $d = 1$ mm. Die zylinderförmige Abschirmung hatte einen Innenradius von $b = 15$ mm. Als Impedanz $Z_a$ wurde ein metallischer Kurzschluß verwendet, für $Z_b$ die Impedanz des Kondensators, zwischen dessen Platten sich nur ein ringförmiger Abstandshalter aus Teflon befand. Die maximale Meßfrequenz wird durch die geometrischen Größen $a_e$, b und d sowie durch die Materialparameter $\varepsilon$ und $\mu$ festgelegt. Folgende Bedingungen müssen erfüllt sein:

$$\nu < \frac{c}{\pi(a_e + b)}$$

$$\nu \ll \frac{c}{2\pi d |\sqrt{\varepsilon\mu}|}$$

Die erste Ungleichung gibt an, ab welcher Frequenz höhere Moden, d. h. geänderte elektromagnetische Feldverteilungen im Bereich der Materialprobe relevant werden, die eine eindeutige Bestimmung der Impedanz nicht mehr zulassen (siehe hierzu: S. F. Adam, Microwave Theory and Applications, Prentice-Hall, Inc., 1969, 1. Auflage, Kapitel 2.2, S. 42). Die zweite Ungleichung erklärt sich daraus, daß bei der Herleitung von Gleichung 6 zur Bestimmung der dielektrischen Funktion vorausgesetzt wurde, daß das elektrische Feld zwischen den Kondensatorplatten nur eine Komponente parallel zu den Flächennormalen der Platten hat. Die Feldverzerrungen werden mit zunehmendem Plattenabstand aber größer, so daß $|kd| \ll 1$ gefordert werden muß. Bei einer Verkleinerung der Radien $a_e$ und b und bei Verwendung dünner Materialproben vergrößert sich also die maximale Meßfrequenz, bis zu der eine Bestimmung von $\varepsilon$ möglich ist.

Beispiel 3

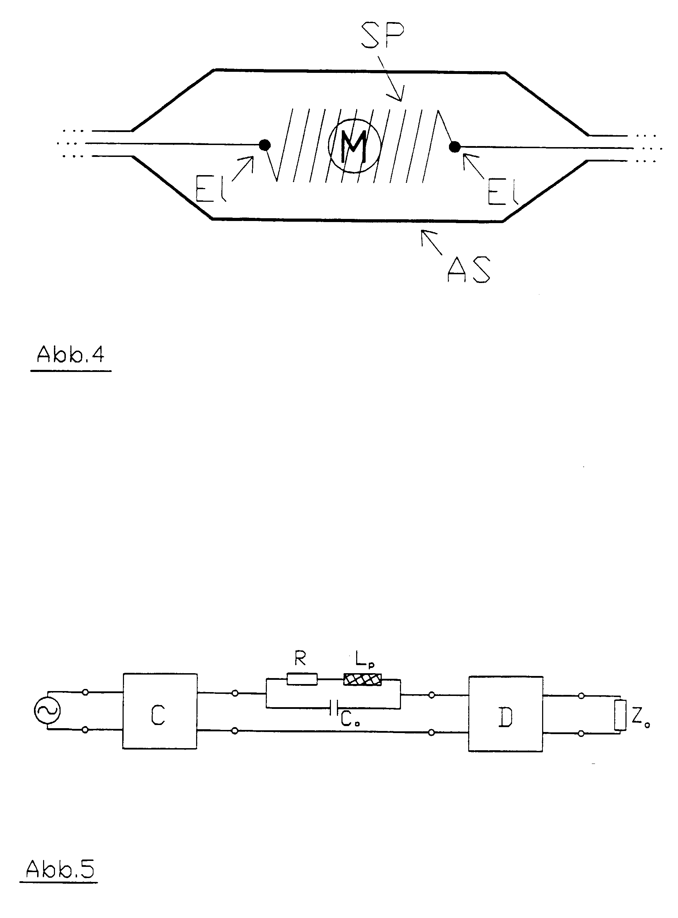

Im folgenden wird die Erfindung am Beispiel der Bestimmung der komplexen Induktivität einer Spule SP, die ein Material M mit komplexer magnetischer Permeabilität enthält, erläutert. Es kann sich hierbei beispielsweise um eine Materialprobe oder einen Ferritkern handeln. Die Spule ist in der Meßzelle an zwei Elektroden El angeschlossen (siehe Abb. 4). Der übrige Meßaufbau sei so wie im Beispiel 1 beschrieben. Das Ersatzschaltbild der Anordnung ist in Abb. 5 dargestellt. Die Impedanz der Spule besteht aus einem ohmschen Widerstand R mit in Serie geschalteter komplexer Induktivität $L_p$, hervorgerufen durch das Material M (die Induktivität der leeren Spule, $L_o$, ist eine reelle Größe). Dazu ist eine Kapazität $C_o$ parallelgeschaltet, welche die Eigenresonanz der Spule berücksichtigt. $C_o$ wird im wesentlichen durch die Kapazitäten zwischen den Windungen der Spule hervorgerufen. Befindet sich die Probe daher zentrisch in der Spule und ist ihre Querschnittsfläche kleiner als die Querschnittsfläche der Spule, so gilt der Wert $C_o$ für die Spule mit Probe und auch für die leere Spule. Zusätzlich zu den bereits in Beispiel 1 definierten Größen werden die folgenden Symbole benutzt:

SP  Spule
EI  Elektroden der Meßzelle zum Anschluß der Spule
R  ohmscher Widerstand der Spule
$C_o$  Kapazität der Spule
$L_o$  Induktivität der leeren Spule
$L_p$  komplexe Induktivität der Spule, in der sich das Material M befindet
$\hat{f}$  Verhältnis von Materialvolumen zum Volumen der Spule
N  Entmagnetisierungsfaktor
$\chi$  komplexe magnetische Suszeptibilität, $\chi = \mu - 1$

Ersetzt man die Spule durch einen metallischen Kurzschluß gleicher Länge, so gilt wieder $Z_a = 0$ und Gleichung 5 kann benutzt werden. Um wie in Beispiel 1 die Kapazitäten zwischen Innenleiter und Abschirmung konstant zu halten, kann dazu beispielsweise ein metallischer Zylinder benutzt werden, dessen Innen- und Außendurchmesser denjenigen der verwendeten Spule entsprechen.

Als Impedanz $Z_b$ wird die Spule ohne Materialprobe benutzt:

$$Z_b = \frac{R + i\omega L_o}{1 - \omega^2 C_o L_o + i\omega C_o R}$$

Die Größen $L_o, C_o$ und R kann man beispielsweise wie folgt ermitteln:

Für $\nu < 1$ MHz gilt im allgemeinen $Z_b = R + i\omega L_o$ und da in diesem Bereich Mehrfachreflektionen zu vernachlässigen sind:

$$L_o = \frac{1}{i\omega} \cdot \left\{ 2Z_o \left( \frac{S_{21}^a}{S_{21}^b} - 1 \right) - R \right\}$$

Bei Erreichen der Resonanzfrequenz

$$\omega_{res}^2 = 1/(L_o C_o)$$

wird $S_{21}^b / S_{21}^a$ minimal ( für $R = 0$ unabhängig von Mehrfachreflektionen), so daß die obige Beziehung die Bestimmung von $C_o$ erlaubt. Im Falle $\omega^2 C_o L_o \ll 1$ kann man $C_o = 0$ setzen und alle angeführten Gleichungen entsprechend vereinfachen. Der Widerstand R der Spule ist auf Grund des Skin-Effektes oberhalb von ca. 1 MHz frequenzabhängig. In diesem Bereich gilt aber i. a. $\omega L_o \gg R$. R kann daher durch eine einfache Gleichstromwiderstandsmessung bestimmt werden.

Somit läßt sich also $Z_b$ aus $R, L_o$ und $C_o$ berechnen und die Impedanz Z der Spule mit Materialprobe nach Gleichung 5 aus den gemessenen Transmissionskoeffizienten $S_{21}^{mess}$, $S_{21}^a$ und $S_{21}^b$ bestimmen. Im Niederfrequenzbereich, wo Mehrfachreflektionen keine Rolle spielen und $\omega L_o \ll 1$ gilt, ist $S_{21}^a = S_{21}^b$ und man benutzt die Gleichung

$$Z = 2Z_o \left( \frac{S_{21}^a}{S_{21}^{mess}} - 1 \right)$$

Die komplexe Induktivität der Spule mit Probe ergibt sich dann zu

$$L_p = \frac{Z(1+i\omega C_o R)\text{-}R}{i\omega + \omega^2 C_o Z}$$

Bei 0 Hz ist natürlich nur der ohmsche Widerstand der Spule meßbar und die untere Grenzfrequenz zur Bestimmung der komplexen Induktivität hängt vom Auflösungsvermögen des verwendeten Meßinstrumentes ab.

Aus $L_p$ läßt sich über die Berechnung der magnetischen Feldenergie in der Spule auch die komplexe relative Permeabilität μ des Materials ermitteln. Wenn $a_M$ die größte Dimension der Materialprobe bezeichnet (für eine Kugel ist dies beispielsweise der Radius), so erhält man für den Fall $|ka_M| \ll 1$ folgende Bestimmungsgleichung für $\mu = 1 + \chi$:

$$0 = L_p - L_o \cdot \left\{ (1 - f) + f \frac{1 + \chi}{(1 + \hat{N}\chi)^2} \right\}$$

Dabei wurde das Außenfeld der magnetisierten Probe vernachlässigt. Ist die Ungleichung $|ka_M| \ll 1$ nicht mehr erfüllt, so muß auch der Einfluß von Wirbelströmen in dem Material berücksichtigt werden (Beispiele für verschiedene Geometrien findet man in: Landau and Lifshitz, Electrodynamics of Continuous Media, Pergamon Press, 1960, 1. Auflage, Kapitel 7, S. 193).

Beispiel 4

Meßaufbau und Vorgehensweise seien so wie in Beispiel 2 beschrieben, nur mit dem Unterschied, daß die Länge des metallischen Kurzschlusses $d_k$ und die Länge des isolierenden Abstandshalters $d_c$ sich voneinander und von der Länge d der zu bestimmenden Impedanz unterscheiden können. Werden die Elektroden nun auf die Oberflächen des Kurzschlusses bzw. des Abstandshalters gedrückt, so resultiert die so erzeugte Änderung der Länge der Übertragungsleitung in einer einfachen Phasenverschiebung Δφ der gemessenen Transmissionskoeffizienten. Benutzt man die Konvention, daß für die Phase des Transmissionskoeffizienten einer Koax-Luftleitung $\frac{d\phi}{d\omega} < 0$ gilt, so ist bei der Messung mit dem metallischen Kurzschluß

$$\Delta\phi_k = \frac{\omega}{c}(d_k - d)$$

bzw. bei der Messung mit Abstandshalter

$$\Delta\phi_c = \frac{\omega}{c}(d_c - d)$$

Der Elektrodenabstand kann daher mathematisch konstant gehalten werden, indem die Phase des gemessenen Transmissionskoeffizienten $S_{21}^a$ bzw. $S_{21}^b$ entsprechend verschoben wird. Zur Berechnung der zu bestimmenden Impedanz wird $S_{21}^a$ also ersetzt durch $S_{21}^a \cdot e^{i\Delta\phi_k}$ bzw. $S_{21}^b$ durch $S_{21}^b \cdot e^{i\Delta\phi_c}$. Es ist auch möglich, $d_k = 0$ zu wählen, das heißt für die Messung von $S_{21}^a$ die Elektroden einfach gegeneinander zu drücken.

**Patentansprüche**

1. Verfahren zur Bestimmung von elektromagnetischen Impedanzen im Frequenzbereich zwischen 0 Hz und 10 GHz, vorzugsweise von 0 Hz bis 2 GHz, durch Messung des komplexen Transmissionskoeffizienten einer Übertragungsstrecke, die aus einer Übertragungsleitung mit einer in die Übertragungsleitung eingeschalteten Meßzelle und einer ausgangsseitig angeschlossenen Abschlußimpedanz besteht, bei dem man

   a) die zu bestimmende Impedanz in der Meßzelle an zwei Elektroden anschließt oder zwischen diesen realisiert und den resultierenden Transmissionskoeffizienten der Übertragungsstrecke mißt,

   b) an dieselben Elektroden wie in a) anstelle der zu bestimmenden Impedanz eine erste Impedanz anschließt oder zwischen diesen realisiert, wobei diese Impedanz einen bekannten Wert besitzt, der den Betrag des resultierenden ersten Transmissionskoeffizienten der Übertragungsstrecke nicht verschwinden läßt, und den resultierenden Transmissionskoeffizienten der Übertragungsstrecke mißt,

**dadurch gekennzeichnet,** daß

c) eine zweite Messung wie in b) durchgeführt wird, mit einer von der ersten Impedanz verschiedenen zweiten Impedanz, deren Impedanzwert bekannt ist, wobei ein zweiter Transmissionskoeffizient gemessen wird und daß der Impedanzwert der zu bestimmenden Impedanz nur aus den ersten und zweiten Transmissionskoeffizienten und dem bei der zu bestimmenden Impedanz gemessenen Transmissionskoeffizienten sowie den Impedanzwerten der beiden bekannten Impedanzen berechnet wird.

2. Verfahren zur Bestimmung von elektromagnetischen Impedanzen im Frequenzbereich zwischen 0 Hz und 10 GHz, vorzugsweise von 0 Hz bis 2 GHz, durch Messung der komplexen Spannung an einer ausgangsseitig angeschlossenen Abschlußimpedanz einer Übertragungsstrecke, die aus einer Übertragungsleitung mit einer in die Übertragungsleitung eingeschalteten Meßzelle besteht und an eine ideal angepaßte und somit reflexionsfreie Signalquelle angeschlossen ist, bei dem man

a) die zu bestimmende Impedanz in der Meßzelle an zwei Elektroden anschließt oder zwischen diesen realisiert und die resultierende Spannung an der Abschlußimpedanz der Übertragungsstrecke mißt,

b) an dieselben Elektroden wie in a) anstelle der zu bestimmenden Impedanz eine erste Impedanz anschließt oder zwischen diesen realisiert, wobei diese Impedanz einen bekannten Wert besitzt, der den Betrag der resultierenden ersten Spannung an der Abschlußimpedanz der Übertragungsstrecke nicht verschwinden läßt, und die resultierende Spannung an der Abschlußimpedanz der Übertragungsstrecke mißt,

**dadurch gekennzeichnet,** daß

c) eine zweite Messung wie in b) durchgeführt wird, mit einer von der ersten Impedanz verschiedenen zweiten Impedanz, deren Impedanzwert bekannt ist, wobei eine zweite Spannung gemessen wird, und daß der Impedanzwert der zu bestimmenden Impedanz nur aus der ersten und zweiten Spannung und der bei der zu bestimmenden Impedanz gemessenen Spannung sowie den Impedanzwerten der beiden bekannten Impedanzen berechnet wird.

3. Verfahren nach Anspruch 1 oder 2, dadurch gekennzeichnet, daß die Elektroden für die Messungen einen zueinander fixierten Abstand aufweisen.

4. Verfahren nach Anspruch 1 oder 2, dadurch gekennzeichnet, daß die zu bestimmende Impedanz, die erste und die zweite Impedanz unterschiedliche geometrische Längen aufweisen, wobei der Abstand der Elektroden der jeweiligen geometrischen Länge der Impedanz angepaßt wird, und daß der Elektrodenabstand rechnerisch konstant gehalten wird durch eine der jeweiligen Längendifferenz zwischen bekannter und unbekannter Impedanz entsprechende Phasenkorrektur der gemessenen Transmissionskoeffizienten bzw. der gemessenen Spannungen.

5. Verfahren nach Anspruch 3 oder 4, dadurch gekennzeichnet, daß

a) die zu bestimmende Impedanz sich zwischen den zwei zu Flächen ausgeformten metallischen Elektroden der Meßzelle befindet und in bezug auf die Abschlußimpedanz der Übertragungsstrecke in Serie geschaltet ist, und

b) man die erste und zweite Impedanz durch einen metallischen Kurzschluß zwischen den Elektroden und durch die Elektroden, zwischen denen sich ein Luftspalt befindet, realisiert.

6. Verfahren nach Anspruch 3 oder 4, dadurch gekennzeichnet, daß

a) die zu bestimmende Impedanz sich zwischen den zwei zu Flächen ausgeformten metallischen Elektroden der Meßzelle befindet und in bezug auf die Abschlußimpedanz der Übertragungsstrecke in Serie geschaltet ist und

b) man die erste und zweite Impedanz durch einen metallischen Kurzschluß zwischen den Elektroden und durch die Elektroden, zwischen denen sich ein Material mit beliebiger und im verwendeten Meßbereich frequenzunabhängiger und verlustfreier dielektrischer Funktion befindet, realisiert.

7. Verfahren nach Anspruch 3 oder 4, dadurch gekennzeichnet, daß

a) die zu bestimmende Impedanz sich zwischen den zwei zu Flächen ausgeformten metallischen Elektroden der Meßzelle befindet und in bezug auf die Abschlußimpedanz der Übertragungsstrecke in Serie geschaltet ist und

b) man die erste und zweite Impedanz durch einen metallischen Kurzschluß zwischen den Elektroden und durch die Elektroden, zwischen denen sich ein Material mit beliebiger, aber im verwendeten Meßbereich bekannter dielektrischer Funktion befindet, realisiert.

8. Verfahren nach Anspruch 3 oder 4, dadurch gekennzeichnet, daß

a) die zu bestimmende Impedanz in bezug auf die Abschlußimpedanz der Übertragungsstrecke in Serie geschaltet ist und

b) man die erste und zweite Impedanz durch einen metallischen Kurzschluß zwischen den Elektroden und durch eine Spule zwischen den Elektroden realisiert.

9. Verfahren nach Anspruch 3 oder 4 zur Bestimmung des Real- und Imaginärteils der dielektrischen Funktion eines Materials, dadurch gekennzeichnet, daß man die Impedanz der Kondensatoranordnung, die aus den zwei zu Flächen ausgeformten metallischen Elektroden der Meßzelle und dem Material zwischen diesen Flächen besteht, bestimmt.

10. Verfahren nach Anspruch 3 zur Bestimmung des Realund Imaginärteils der magnetischen Permeabilität eines Materials, dadurch gekennzeichnet, daß die Impedanz einer Spule bestimmt wird, in deren Innerem sich das Material befindet.

11. Verfahren nach Anspruch 3 oder 4, dadurch gekennzeichnet, daß bei der Berechnung der zu bestimmenden Impedanz ein Computer benutzt wird.

12. Verfahren nach Anspruch 4, dadurch gekennzeichnet, daß zur rechnerischen Realisierung des konstanten Elektrodenabstands mittels Phasenkorrektur ein Computer benutzt wird.

## Claims

1. A method for the determination of electromagnetic impedances in the frequency range between 0 Hz and 10 GHz, preferably between 0 Hz and 2 GHz, by measuring the complex transmission coefficient of a transmission path, said transmission path comprising a transmission line including a measurement cell and a terminating impedance connected at an output side; comprising

a) in said measurement cell, connecting the impedance to be determined to two electrodes or realizing the impedance between said electrodes and measuring the resultant transmission coefficient of the transmission path,

b) connecting, in place of the impedance to be determined, a first impedance to the same electrodes as in a) or realizing said first impedance between said electrodes, said impedance having a known value which does not cause the amount of the resultant first transmission coefficient of the transmission path to vanish, and measuring the resultant transmission coefficient of the transmission path,

**characterized by**

c) performing a second measurement as in b) with a second impedance having a known impedance value and being different from said first impedance, wherein a second transmission coefficient is measured, and calculating the impedance value of the impedance to be determined only from said first and second transmission coefficients, said transmission coefficient measured at the impedance to be determined, and said impedance values of said two known impedances.

2. A method for the determination of electromagnetic impedances in the frequency range between 0 Hz and 10 GHz, preferably between 0 Hz and 2 GHz, by measuring the complex voltage at a terminating impedance of a transmission path, connected at an output side, said transmission path comprising a transmission line including a measurement cell, and being connected to an ideally adapted and thus reflection-free signal source, comprising

a) in said measurement cell, connecting the impedance to be determined to two electrodes or realizing the impedance between said electrodes and measuring the resultant voltage at the terminating impedance of the transmission path,

b) connecting, in place of the impedance to be determined, a first impedance to the same electrodes as in a) or realizing said first impedance between said electrodes, said impedance having a known value which does not cause the amount of the resultant first voltage at the terminating impedance of the transmission path to vanish, and measuring the resultant voltage at the terminating impedance of the transmission path,

**characterized by**

c) performing a second measurement as in b) with a second impedance having a known impedance value and being different from said first impedance, wherein a second voltage is measured, and calculating the impedance value of the impedance to be determined only from said first and second voltages, said voltage measured at the impedance to be determined, and said impedance values of said two known impedances.

3. The method according to claims 1 or 2, characterized in that the electrodes provided for the measurements have a fixed distance relative to each other.

4. The method according to claims 1 or 2, characterized in that the impedance to be determined, the first impedance and the second impedance have different geometrical lengths, the distance between the electrodes being adapted to the respective geometrical length of the impedance, and that the electrode distance is kept arithmetically constant by a phase correction of the measured transmission coefficients and the measures voltages, respectively, which is performed in correspondence with the respective length difference between the known impedance and the unknown impedance.

5. The method according to claims 3 or 4, characterized in that

a) the impedance to be determined is arranged between the two areal metallic electrodes of the measurement cell and is connected in series relative to the terminating impedance of the transmission path, and

b) the first and second impedances are realized by a metallic short between said electrodes and by said electrodes themselves with an air gap in-between.

6. The method according to claims 3 or 4, characterized in that

a) the impedance to be determined is arranged between the two areal metallic electrodes of the measurement cell and is connected in series relative to the terminating impedance of the transmission path, and

b) the first and second impedances are realized by a metallic short between said electrodes and by said electrodes themselves with a material in-between having any, but within the measurement range used, frequency-independent and loss-less dielectric function.

7. The method according to claims 3 or 4, characterized in that

a) the impedance to be determined is arranged between the two areal metallic electrodes of the measurement cell and is connected in series relative to the terminating impedance of the transmission path, and

b) the first and second impedances are realized by a metallic short between said electrodes and by said electrodes themselves with a material in-between having any, but within the measurement range used, known dielectric function.

8. The method according to claims 3 or 4, characterized in that

a) the impedance to be determined is connected in series relative to the terminating impedance of the transmission path, and

b) the first and second impedances are realized by a metallic short between said electrodes and by a coil between the electrodes.

9. The method according to claims 3 or 4 for the determination of the real and imaginary part of the dielectric function of a material, characterized by determining the impedance of a capacitor arrangement, which consists of the two areal metallic electrodes of the measurement cell and of the material between the areal regions.

10. The method according to claim 3 for the determination of the real and the imaginary part of the magnetic permeability of a material, characterized by determining the impedance of a coil containing said material.

11. The method according to claim 3 or 4, characterized in that the step of calculating the impedance to be determined includes using a computer.

12. The method according to claim 4, characterized in that the step of realizing the constant electrode distance mathematically includes using a computer for correcting said phases.

**Revendications**

1. Procédé pour la détermination d'impédances électromagnétiques dans la gamme de fréquences comprises entre 0 Hz et 10 GHz, de préférence de 0 Hz à 2 GHz, par mesure du coefficient de transmission complexe d'une voie de transmission, qui comprend un câble de transmission avec une cellule de mesure ou capteur mis en circuit sur le câble de transmission et une impédance terminale connectée en sortie, procédé dans lequel

a) on connecte dans le capteur l'impédance à déterminer à deux électrodes, ou on la réalise entre celles-ci, et on mesure le coefficient de transmission résultant de la voie de transmission,
b) aux mêmes électrodes qu'en a) au lieu de l'impédance à déterminer, on connecte une première impédance, ou on la réalise entre celles-ci, cette impédance ayant une valeur connue qui ne fait pas disparaître la valeur du premier coefficient de transmission résultant de la voie de transmission, et on mesure le coefficient de transmission résultant de la voie de transmission,

caractérisé en ce que

c) une deuxième mesure est effectuée comme en b), avec une deuxième impédance, différente de la première impédance, dont la valeur d'impédance est connue, un deuxième coefficient de transmission étant alors mesuré, et en ce que la valeur d'impédance de l'impédance à déterminer est calculée seulement à partir des premier et deuxième coefficients de transmission et à partir du coefficient de transmission mesuré pour l'impédance à déterminer, ainsi qu'à partir des valeurs d'impédance des deux impédances connues.

2. Procédé pour la détermination d'impédances électromagnétiques dans la gamme de fréquences comprises entre 0 Hz et 10 GHz, de préférence de 0 Hz à 2 GHz, par mesure de la tension complexe au niveau d'une impédance terminale connectée en sortie d'une voie de transmission, qui comprend un câble de transmission avec une cellule de mesure ou capteur mis en circuit sur le câble de transmission, et qui est connectée à une source de signaux adaptée de façon idéale et donc exempte de réflexions, procédé dans lequel

a) on connecte dans le capteur l'impédance à déterminer à deux électrodes, ou on la réalise entre celles-ci, et on mesure la tension résultante au niveau de l'impédance terminale de la voie de transmission,
b) aux mêmes électrodes qu'en a), au lieu de l'impédance à déterminer, on connecte une première impédance, ou on la réalise entre celles-ci, cette impédance ayant une valeur connue, qui ne fait pas disparaître la valeur de la première tension résultante au niveau de l'impédance terminale de la voie de transmission, et on mesure la tension résultante au niveau de l'impédance terminale de la voie de transmission,

caractérisé en ce que

c) une deuxième mesure est effectuée comme en b), avec une deuxième impédance, différente de la première

**EP 0 569 572 B1**

impédance, dont la valeur d'impédance est connue, une deuxième tension étant alors mesurée, et en ce que la valeur d'impédance de l'impédance à déterminer est calculée seulement à partir des première et deuxième tensions et à partir de la tension mesurée pour l'impédance à déterminer, ainsi qu'à partir des valeurs d'impédance des deux impédances connues.

3. Procédé selon la revendication 1 ou 2, caractérisé en ce que les électrodes pour les mesures présentent une distance réciproque fixe.

4. Procédé selon la revendication 1 ou 2, caractérisé en ce que l'impédance à déterminer, la première et la deuxième impédance présentent des longueurs géométriques différentes, la distance des électrodes étant adaptée à la longueur géométrique respective de l'impédance, et en ce que la distance des électrodes est maintenue constante par calcul par l'intermédiaire d'une correction de phase des coefficients de transmission mesurés ou des tensions mesurées correspondant à la différence de longueur respective entre les impédances connue et inconnue.

5. Procédé selon la revendication 3 ou 4, caractérisé en ce que

   a) l'impédance à déterminer se trouve entre les deux électrodes métalliques du capteur, façonnées en surfaces, et est connectée en série par rapport à l'impédance terminale de la voie de transmission, et
   b) on réalise les première et deuxième impédances par un court-circuit métallique entre ies électrodes et à travers les électrodes, entre lesquelles se trouve un entrefer.

6. Procédé selon la revendication 3 ou 4, caractérisé en ce que

   a) l'impédance à déterminer se trouve entre les deux électrodes métalliques du capteur, façonnées en surfaces, et est connectée en série par rapport à l'impédance terminale de la voie de transmission, et
   b) on réalise les première et deuxième impédances par un court-circuit métallique entre les électrodes et à travers les électrodes, entre lesquelles se trouve un matériau doté d'une fonction diélectrique quelconque sans pertes et indépendante de la fréquence dans la gamme de mesure utilisée.

7. Procédé selon la revendication 3 ou 4, caractérisé en ce que

   a) l'impédance à déterminer se trouve entre les deux électrodes métalliques du capteur, façonnées en surfaces, et est connectée en série par rapport à l'impédance terminale de la voie de transmission, et
   b) on réalise les première et deuxième impédances par un court-circuit métallique entre les électrodes et à travers les électrodes, entre lesquelles se trouve un matériau doté d'une fonction diélectrique quelconque mais connue dans la gamme de mesure utilisée.

8. Procédé selon la revendication 3 ou 4, caractérisé en ce que

   a) l'impédance à déterminer est connectée en série par rapport à l'impédance terminale de la voie de transmission et
   b) on réalise les première et deuxième impédances par un court-circuit métallique entre les électrodes et à travers une bobine entre les électrodes.

9. Procédé selon la revendication 3 ou 4 pour la détermination de la composante réelle et imaginaire de la fonction diélectrique d'un matériau, caractérisé en ce que l'on détermine l'impédance de la configuration de condensateurs qui comprend les deux électrodes métalliques du capteur, façonnées en surfaces, et le matériau entre ces surfaces.

10. Procédé selon la revendication 3 pour la détermination de la composante réelle et imaginaire de la perméabilité magnétique d'un matériau, caractérisé en ce que l'on détermine l'impédance d'une bobine à l'intérieur de laquelle se trouve le matériau.

11. Procédé selon la revendication 3 ou 4, caractérisé en ce que l'on utilise un ordinateur pour le calcul de l'impédance à déterminer.

12. Procédé selon la revendication 4, caractérisé en ce qu'un ordinateur est utilisé pour la réalisation mathématique de la distance constante entre les électrodes au moyen d'une correction de phase.

17

Abb.1

Abb.2

**Abb.3**

EP 0 569 572 B1

Abb.4

Abb.5